(19) Europäisches Patentamt
European Patent Office
Office européen des brevets

(11) **EP 1 211 517 A2**

(12) **EUROPEAN PATENT APPLICATION**

(43) Date of publication:
05.06.2002 Bulletin 2002/23

(51) Int Cl.⁷: **G01R 33/12**

(21) Application number: **01310077.1**

(22) Date of filing: **30.11.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: 04.12.2000 KR 2000083402
30.05.2001 KR 2001030181
10.09.2001 KR 2001055598

(71) Applicant: **Evergreen Korea Corp.**
**Sungdong-gu, Seoul (KR)**

(72) Inventors:
• **Kim, Hoon**
**Kangnam-gu, Seoul 135-230 (KR)**
• **Nagamune, Yasushi**
**Tsukuba-shi, Ibaraki 305-0031 (JP)**
• **Lee, Geun-Taek**
**Yongsan-gu, Seoul 140-040 (KR)**
• **Chung, Suk-Hwan**
**Yongsan-gu, Seoul 140-040 (KR)**

(74) Representative: **Harrison Goddard Foote**
**Belgrave Hall**
**Belgrave Street**
**Leeds LS2 8DD (GB)**

(54) **Apparatus and method for measuring hall effect**

(57) Disclosed are apparatus and method for measuring Hall effect related-values in a semiconductor, such as a mobility, a carrier concentration and a resistivity using a Hall effect. A sample (S) is loaded into a IC socket (20) or a similar target, which is fixed on the inside of a heat insulating material container capable of containing injected liquid nitrogen. The Hall effect related-values are measured using a moving member (60) for moving a pair of permanent magnets (M1,M2) to an outside of the heat insulating material container. The measuring equipment has a simple structure, and a measuring operation is simple. A level of an imput voltage of a sample is measured depending on a constant current that is supplied by a constant current supplying unit contained in a Hall voltage measurement unit. A measurement error detection unit detects and displays a measurement error of the sample using the level of the measured input voltage. Since the measurement error is detected before measuring the Hall effect, the measurement error can be excluded.

FIG.2

EP 1 211 517 A2

**Description**

## BACKGROUND OF THE INVENTION

### Field of the Invention

The present invention relates to an apparatus and method for measuring a Hall effect, and more particularly, to an apparatus and method for measuring a Hall effect of a sample while applying a magnetic field to the sample, in which a sample holder is established within a sample container of a heat insulating material, a Hall device for measuring the Hall effect is fixed to the sample holder, and a permanent magnet supporter provided with a permanent magnet is coupled with the sample holder. Further, the invention relates to an apparatus and method for measuring a Hall effect of a sample under an extremely low temperature atmosphere provided in the sample container simply by injecting liquid nitrogen into the sample container.

### Description of the Related Art

In general, Hall device is a device for calibrating/detecting or calculating a magnetic field or a current by using the Hall effect. Hall device is manufactured in a thin plate form using germanium (Ge), indium antimonide (InSb) and gallium arsenide (GaAs), each of which has large Hall coefficients and small temperature coefficients.

If a conductor or a semiconductor is placed within the magnetic field induced in a direction normal to a current flowing therethrough, a current flows due to a potential difference (Hall voltage) generated in the direction normal to the current and the magnetic field. This phenomenon is known as the Hall effect. A carrier (electron or hole) density within the conductor or the semiconductor is deflected due to the magnetic field to thereby generate the Hall voltage.

Generally, in order to measure the Hall effect of the Hall device in a conventional measuring apparatus, a sample is set within a specially designed vacuum container or refrigerator, which is capable of containing liquid nitrogen, and also a large-sized electromagnet is used.

Then, the conventional measuring apparatus has the following disadvantages:

First, since the specially designed vacuum container or refrigerator and the large-sized electromagnet are needed, a cost of equipment investments is very high.

Second, since a size of elements contained in the apparatus is large, a process of performing a measurement is difficult and complicated.

Third, since a constant current is applied to the sample using a probe and the Hall voltage is then measured, the apparatus becomes large-scaled. Also, it is difficult to use the same sample at different equipments and to perform continuous measurements, resulting in an increase of measurement time.

## SUMMARY OF THE INVENTION

Therefore, it is an object of the present invention to provide an apparatus and a method for measuring a Hall effect, capable of remarkably reducing a cost of equipment investments by providing the apparatus with a simple structure.

It is another object of the present invention to provide an apparatus and a method for measuring a Hall effect, capable of measuring the Hall effect of a sample in a simple and easy way.

It is further another object of the present invention to provide an apparatus and a method for measuring a Hall effect, capable of continuously measuring the Hall effects of a plurality of samples.

In accordance with an aspect of the present invention, there is provided an apparatus for measuring a Hall effect. The apparatus comprises: a sample holder on which a sample is set; a sample container which is provided with the sample holder; a permanent magnet supporter in which a pair of permanent magnets are established facing with each other, the permanent magnet supporter being attachably and detachably coupled with the sample container such that the sample is positioned between the pair of permanent magnets; and a Hall voltage measurement means for applying a current to the sample and measuring a Hall voltage outputted from the sample.

Preferably, the sample container has a heat exchange material supplying hole for supplying a heat exchange material.

Also, the sample holder is an IC socket capable of mounting a plurality of samples.

As one example, the sample container comprises: a top case on which a sample holder is installed; and a bottom case coupled with the top case. Here, a part of a lower face of the bottom case is supported by a pedestal. The pedestal has a pair of guide rails extended from one end of the pedestal and placed below a remaining portion of the lower face of the bottom case. The guide rails guides a movement of the permanent magnet supporter.

The permanent magnet supporter includes: a pair of fixing parts to which the pair of permanent magnets are fixed; and a connection part connected to the fixing parts while maintaining a constant interval between the fixing parts.

The bottom case comprises a heat insulating material formed at an inner surface thereof.

Alternatively, the sample container includes: a top cover which a sample holder is mounted on and a heat exchange material supplying hole is formed in; a heat exchange material container having a receiving space for containing the heat exchange material; a pair of guide plates established at both sides of the heat exchange material container; and a pedestal for supporting the heat exchange material container and the pair of guide plates.

In the above apparatus, the permanent magnet supporter is moved on the pedestal to enclosing the heat exchange material container within the pair of guide plates.

The heat exchange material container is comprised of a heat insulating material.

Selectively, the sample container may include a barrier rib formed crossing the receiving space thereof and spaced apart from a bottom face of the receiving space by a predetermined distance.

Also, the sample container may include a U-shaped heat insulating material inserted into an inside of the receiving space, the U-shaped heat insulating material has one end communicating with the heat exchange material supplying hole and the other end on which the sample is placed.

Alternatively, the Hall voltage measurement means includes: a constant current supplying unit for supplying a constant current to selected two terminals among a plurality of terminals of the sample and for varying a level of the constant current; a Hall voltage detection unit for detecting a Hall voltage outputted from the unselected two terminals of the samples and outputting the detected Hall voltage; a switching unit for applying an output current of the constant current supplying unit to the selected two terminals depending on a user's manipulation, and for outputting the Hall voltage of the unselected two terminals to the Hall voltage detection unit; a current detection unit for detecting a level of the constant current which the constant current supplying unit outputs to the sample; an input voltage detection unit for detecting an input voltage of the sample depending on the constant current which the constant current supplying unit outputs to the sample.

Preferably, the above apparatus further includes a measurement error detection unit for detecting a measurement error of the sample using the level of the input voltage of the sample depending on the current constant which the constant current supplying unit outputs to the sample.

The measurement error detection unit includes: a voltage detection unit for detecting the level of an input voltage of the sample depending on the constant current which the constant current supplying unit outputs to the sample; and a comparator for comparing the output voltage of the voltage detection unit with a predetermined reference voltage and determining whether there is a measurement error or not.

More preferably, the Hall voltage measurement means includes: a plurality of analog-to-digital converters for converting the output signals of the Hall voltage detection unit, the input voltage detection unit and the current detection unit into digital signals; a microprocessor for controlling a switching operation of the switching unit, determining the output current of the constant current supplying unit using a digital signal which is outputted from the current detection unit and converted by the analog-to-digital converter, adjusting the set constant current to output, controlling a polarity of the constant current, and calculating a Hall coefficient-related value using a digital signal which is outputted from the Hall voltage detection unit and the input voltage detection unit and converted by the analog-to-digital conversion unit, and displaying the calculated the Hall coefficient related value; a key input unit for inputting operation commands to the microprocessor depending on the user's manipulation; and a display unit for displaying a calculated value of the Hall effect depending on the control of the microprocessor.

Also, the Hall voltage measurement means includes: a personal computer for setting the constant current by controlling the microprocessor, measuring the Hall voltage and the input voltage, and calculating the Hall coefficient related value by inputting the measured Hall voltage and input voltage; and an interface unit, disposed between the microprocessor and the personal computer, for interfacing data therebetween.

In accordance with another aspect of the present invention, there is provided a method for measuring a Hall coefficient, comprising the steps of: a) inputting a constant current which is being applied to a sample, a magnetic flux density and a thickness of the sample; b) adjusting a level to supply the inputted constant current to the sample; c) sequentially setting four terminals of the sample as two input terminals and two output terminals, and measuring a Hall voltage outputted from the sample and on input voltage of the sample while adjusting polarities of the constant current; d) inserting a permanent magnet supporter in a forward direction, sequentially setting as the input terminal and the output terminal of the sample and measuring the Hall voltage outputted from the sample and the input voltage of the sample while adjusting polarities of the constant current; e) inserting the permanent magnet supporter in a reverse direction, sequentially setting as the input terminal and the output terminal of the sample, and measuring the Hall voltage outputted from the sample and the input voltage of the sample while adjusting polarities of the constant current; and f) substituting a predetermined equation with the values measured in the steps c) to e), and calculating and displaying a Hall coefficient related value.

Preferably, the method further includes a step g) of modifying the magnetic flux density and the thickness of the sample depending on the user's manipulation, and, if a calculation start command is inputted, calculating again the Hall coefficient-related value using the modified magnetic flux density, modified thickness of the sample and the measured value, and displaying the calculated Hall coefficient related value.

Also, if the user sets up a manual mode, the constant current applied to the sample, the magnetic flux density and the thickness of the sample, the Hall voltage and the input voltage of the sample are inputted an the Hal coefficient related value is calculated and the calculated Hall coefficient related value is displayed.

## BRIEF DESCRIPTION OF THE DRAWINGS

The above objects and other advantages of the present invention will become more apparent by describing in detail preferred embodiments thereof with reference to the attached drawings in which:

FIG. 1 is a perspective view showing an apparatus for measuring a Hall effect in accordance with an embodiment of the present invention;
FIG. 2 is a perspective view of a sample container and a permanent magnet supporter in the apparatus for measuring the Hall effect in accordance with an embodiment of the present invention;
FIGS. 3A and 3B are side views explaining an operation of the permanent magnet supporter in the apparatus for measuring a Hall effect in accordance with an embodiment of the present invention;
FIG. 4 is a perspective view showing an apparatus for measuring a Hall effect in accordance with another embodiment of the present invention;
FIG. 5 is an exploded perspective view of a sample container and a permanent magnet supporter in the apparatus for measuring the Hall effect in accordance with another embodiment of the present invention;
FIGS. 6A to 6D are plan views explaining an operation of the permanent magnet supporter in the apparatus for measuring the Hall effect in accordance with another embodiment of the present invention;
FIGS. 7A to 7C are cross-sectional views showing various examples of a heat exchange material container in the apparatus for measuring the Hall effect in accordance with another embodiment of the present invention;
FIG. 8 is a circuit diagram showing a preferred embodiment of a Hall voltage measurement unit applied to the apparatus for measuring the Hall effect in accordance with the present invention;
FIG. 9 is a circuit diagram of a switching unit shown in Fig. 8;
FIG. 10 is a circuit diagram showing another preferred embodiment of the Hall voltage measurement unit applied to the apparatus for measuring the Hall effect in accordance with the present invention;
FIGS. 11A to 11C are signal flowcharts showing an operation of a microprocessor, illustrated in FIG. 10, according to a method for measuring a Hall effect in accordance with the present invention; and
FIG. 12 is a circuit diagram showing a further another preferred embodiment of the Hall voltage measurement unit in accordance with the present invention.

## DETAILED DESCRIPTION OF THE PREFERRED EMBODIMENTS

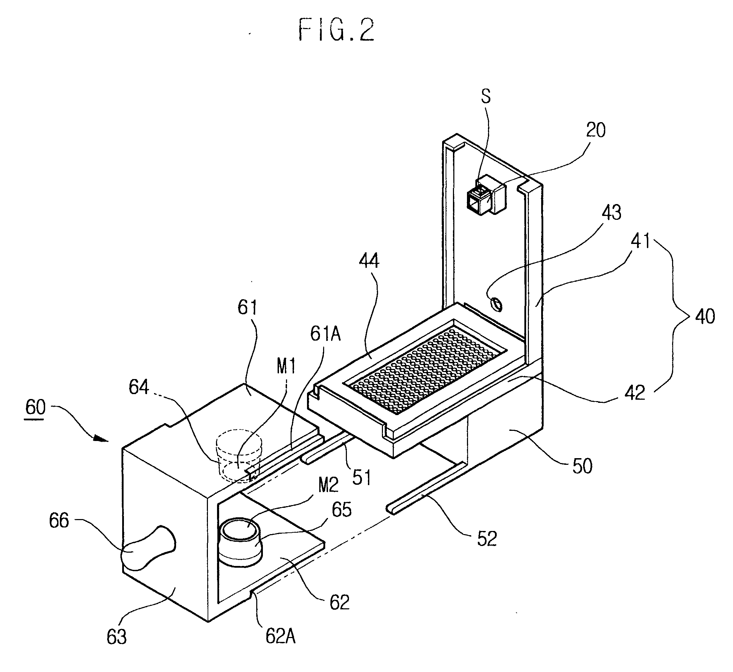

Now, preferred embodiments of the present invention will be described in detail with reference to the annexed drawings.

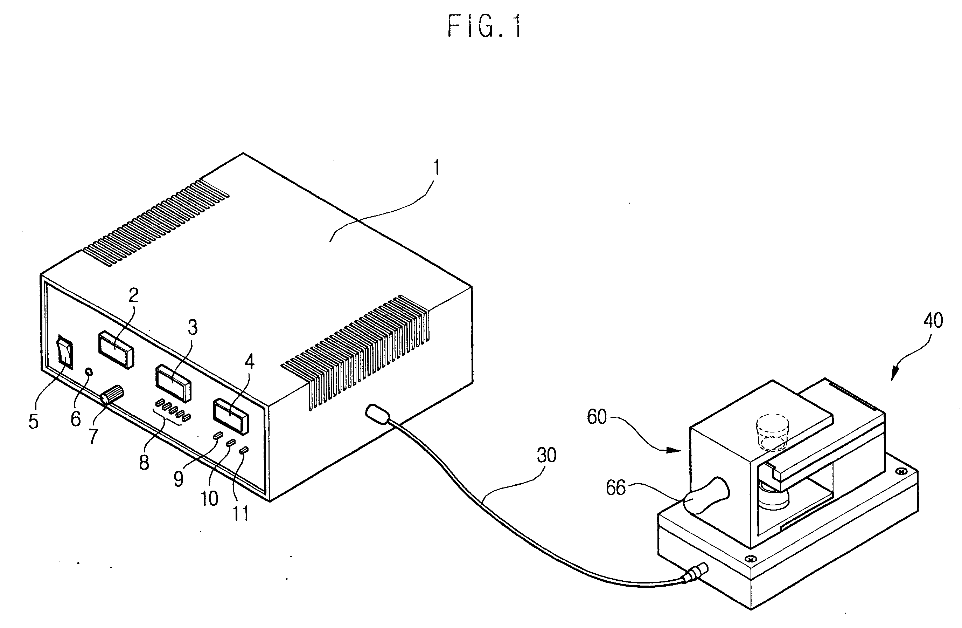

FIG. 1 is a perspective view showing an apparatus for measuring a Hall effect in accordance with an embodiment of the present invention.
Here, a reference numeral 1 represents a main body of the apparatus for measuring the Hall effect. An input voltage display 2, an input current display 3 and a Hall voltage display 4 are established at an upper portion of the front face of the main body 1. The input voltage display 2 displays a measured value of an input voltage, which is applied to an input terminal of a sample according as a constant current is supplied to the sample. The input current display 3 displays a measured value of the constant current supplied to the sample. The Hall voltage display 4 displays a measured value of the Hall voltage induced in the sample according as the constant current is applied thereto.
A power switch 5, a light emitting diode 6, a current adjusting knob 7, a plurality of switch controlling knobs 8, a start/stop button 9, a tap selecting button 10 and a current direction switch 11 are mounted on a lower portion of the front face of the main body 1. The light emitting diode 6 is used to indicate a measurement error. The current adjusting knob 7 is used to adjust a level of the constant current to be applied to the sample. The plurality of the switch controlling knobs 8 are used to set up input terminals and output terminals of the sample. After checking a power and a condition when the power switch 5 is on, the start/stop button 9 is used to start or reset the measurement of the Hall effect. The tap selecting button 10 is used to check a resistance and the Hall voltage of the sample at respective steps. The current direction switch 11 is used to check a hole concentration and a mobility depending on a reverse and forward current.
Referring to FIGS. 1 and 2, a sample container 40 includes a top case 41 and a bottom case 42 coupled with the top case 41. As shown in Fig. 2, the sample container 40 has a sample holder, i.e., an IC socket 20, established at an inner surface of the top case 41. A plurality of sample S, whose Hall effects are being measured, are loaded into the IC socket 20. The IC socket 20 is fixed on a printed circuit board (not shown) and is electrically connected with the main body 1 via the printed circuit board and a connecting wire 30.

Preferably, a heat exchange material supplying hole 43 is formed spaced apart from the IC socket 20-established position in the top case 41. The heat exchange material supplying hole 43 is used to supply a heat exchange material, i.e., liquid nitrogen, into the inside of the sample container 40. A heat shield member 44, for example, a Styrofoam, for a heat shield of the injected liquid nitrogen is established in the inner wall of the bottom case 42.

The bottom case 42 of the sample container 40 is supported by a pedestal 50 by half of the bottom case 42 along its length direction. A pair of guide rails 51 and 52 each having a length corresponding to the other half of the bottom case 42, extend from the pedestal 50.

To generate the magnetic field to a target object to be measured, i.e., the sample S, the apparatus of the present invention includes a permanent magnet supporter 60, and a pair of permanent magnets M1 and M2 are respectively established at an upper portion and a lower portion of the permanent magnet supporter 60. It is preferable that diameters of the permanent magnets M1 and M2 are within a maximum measurable diameter, i.e., 25 mm.

The permanent magnet supporter 60 includes top and bottom holding parts 61 and 62 for holding the pair of the permanent magnets M1 and M2, and a connection part 63 for connecting the top and the bottom holding parts 61 and 62 to be spaced apart from each other.

Magnet holders 64 and 65 are established in the top and the bottom holding parts 61 and 62 facing with each other, respectively, and the permanent magnets M1 and M2 are coupled to surfaces of the magnet holders 64 and 65. Guide grooves 61A and 62A are formed in both external side edges of the top and bottom holding parts 61 and 62 along a length direction of the top and bottom holding parts 61 and 62 such that the guide rails 51 and 52 are inserted into. A handle 66 is established in an external surface of the connection part 63.

At this time, the permanent magnets M1 and M2 are arranged to have opposite polarities to each other. For example, if the bottom face of the permanent magnet M1 is an N polarity, the top face of the permanent magnet M2 is an S polarity.

Hereinafter, an operation of measuring the Hall effect of the sample S in the apparatus for measuring the Hall effect in accordance with an embodiment of the present invention will be described below.

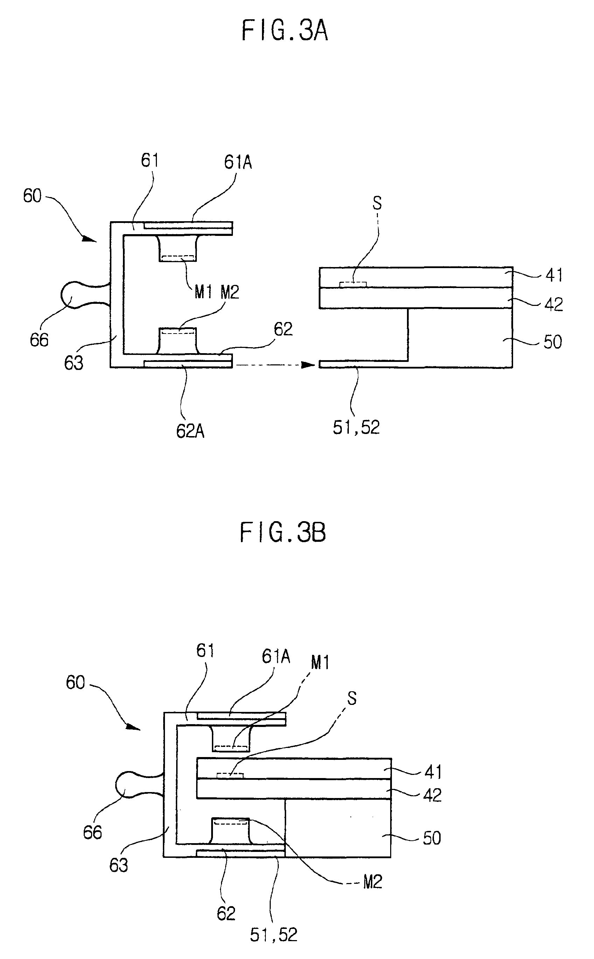

First, an operation of setting the sample to a measurable state will be described with reference to FIGS. 3A and 3B.

Referring to FIG. 3A, at least one sample S is loaded into the IC socket 20, and then, the top case 41 is rotated and coupled with the bottom case. At this time, once the top case 41 is coupled with the bottom case 42, an external light is prevented from being incident to the sample.

Next, if the permanent magnet supporter 60 is moved toward the sample container 40, the guide groove 62A of the bottom holding part 62 is guided to the guide rails 51 and 52 of the pedestal 50 and accordingly the permanent magnet supporter 60 is moved toward the sample container 40.

Referring to FIG. 3B, if the permanent magnet supporter 60 is fully moved, the permanent magnets M1 and M2 are faced to each other in the center of the sample S loaded into the top case 41. Therefore, a magnetic flux density is uniformly formed throughout the sample S by the pair of the permanent magnets M1 and M2.

Thus, after setting the sample S in the magnetic field region and turning on the power switch, the measuring operation is started. At this time, if a contact resistance of the sample S is high, the light emitting diode 6 for indicating the measurement error is turned on. Therefore, it is possible to precisely load the sample S and maintain the contact resistance below a permitted value. The operation of turning on the light emitting diode 6 will be described later.

If the light emitting diode 6 is not turned on, it indicates that the contact resistance of the sample S is below a permitted contact resistance value. The measuring operation is performed according to a following sequence.

First, the current adjusting knob 7 is adjusted while the input current display 3 is checked such that a constant current of a predetermined level is precisely applied to the sample.

Second, an input terminal and an output terminal of the sample S are set up by selectively operating a plurality of the switch control knobs 8.

Third, a voltage applied to the input terminal of the sample S depending on the applied constant current is checked through the input voltage display 2, and the Hall voltage induced in the sample S is checked through the Hall voltage display 4.

After checking the input voltage and the Hall voltage of the sample S, the input terminal and the output terminal of the sample are variably set up by repeating the second and third steps. Then, the input voltages and the Hall voltages, which are differently induced depending on the variably set input terminal and output terminal, are measured.

The above-mentioned measurement of the Hall voltage is performed at a room temperature of about 300 °K. In case where a characteristic of the Hall device is measured at an atmosphere of extreme low temperature, e.g., about 77 °K., the top case 41 is coupled with the bottom case 42 and the liquid nitrogen is injected into the sample container 40 through the heat exchange material supplying hole 43. Then, after the inner temperature of the sample container 40 is lowered to an extreme low temperature, the measurement is performed according to the above-mentioned steps. Liquid nitrogen can be injected, for example, through a funnel. Liquid nitrogen overflowed due to the over injection is rapidly vaporized to the air.

Also, if the user wants to perform the measuring operation under the condition that the magnetic field is not applied, the measurement is performed after the permanent magnet supporter 60 is drawn out the guide rails 51 and 52 of the pedestal 50.

Further, after the permanent magnet supporter 60 is moved and the measuring operation is performed, the permanent magnet supporter 60 is rotated by 180 °C. By doing so, the positions of the permanent magnets M1 and M2 are changed, resulting in a change of the polarities of the permanent magnets from the N polarity to the S polarity, or vice versa. Thus, the Hall coefficient can be measured accurately through a polarity changing effect.

Meanwhile, the above description shows steps of measuring a change of the Hall voltage at a dark state. In case where the change of the Hall voltage is measured at a light state, after temporally opening the top case 41 to expose the sample S to an external light, the top case 41 is coupled with the bottom case 42, and then, the measuring operation is performed, thereby obtaining data identical to the data measured at the light state.

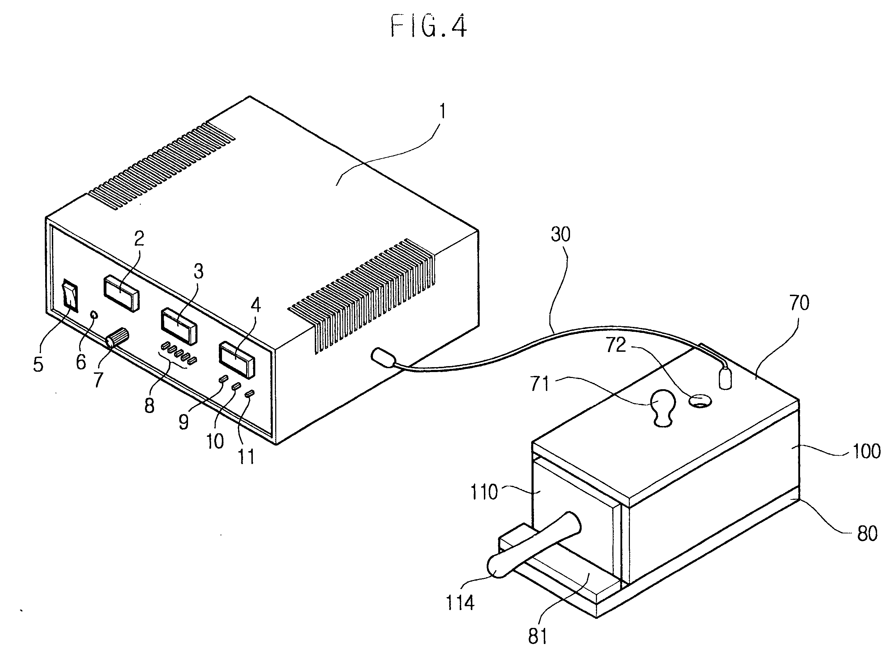

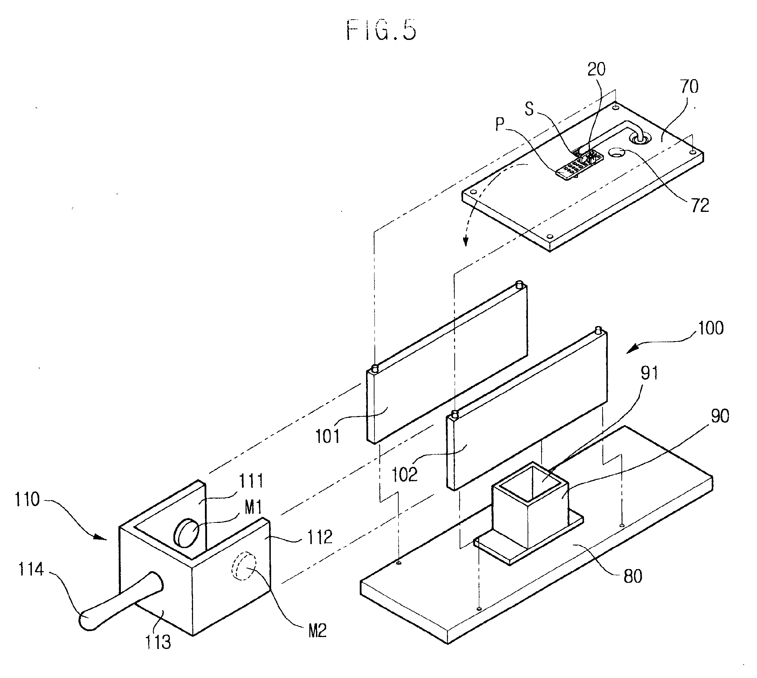

Another embodiment of the sample container and the permanent magnet supporter will be described with reference to FIGS. 4 and 5.

Under the condition that one or more sample S is loaded into a ceramic package, the sample S is set to an IC socket 20 of a sample holder. The IC socket 20, which is electrically connected with a printed circuit board P that is connected to the main body 10, is mounted in the center of an inner face of the top cover 70.

A conductive connecting wire 30 is connected to an outer face of the top cover 70, and the handle 71 is mounted in the center thereof. The heat exchange material supplying hole 72 is punched in a predetermined portion of the top cover 70.

A heat exchange material container 90 is fixedly formed on a portion of the top face of a pedestal 80, and a guide plate 100 for supporting the top cover 70 is mounted on both edges of the pedestal 80. Also, a permanent magnet supporter 110 is movably established such that it slides into the inside of the guide plate 100.

The heat exchange material container 90 has a receiving space 91 therein. The receiving space 91 has a certain depth so that the sample S is sunk into the liquid nitrogen used as the heat exchange material.

The guide plate 100 is comprised of a left guide part 101 and a right guide part 102.

The permanent magnet supporter 110 includes left and right holding parts 111 and 112, and a connection part 113 for connecting the left holding part 111 and the right holding part 112 in a status that they are spaced apart from each other. The connection part 113 has a handle 114, and the permanent magnets M1 and M2 mounted at positions where the left and right holding parts 111 and 112 faces are disposed at a height corresponding to a position of the sample S in the receiving space 91 of the heat exchange material container 90.

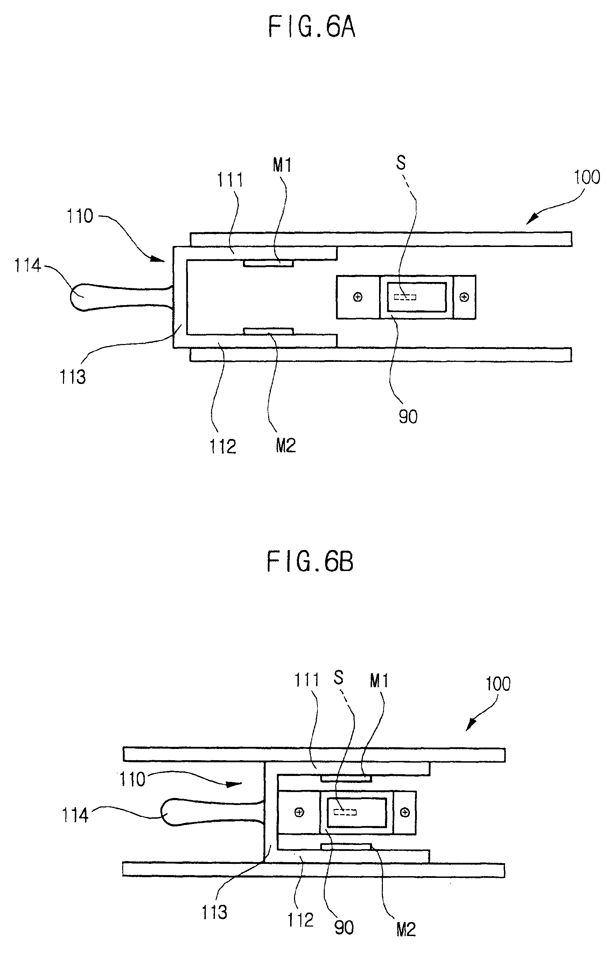

An operation of moving the permanent magnet supporter to the position of the sample will be described below with reference to FIGS. 6A to 6D.

FIG. 6A shows a measurement operation of the Hall device in case where the magnetic field is not applied to the sample S. If the magnetic field is to be applied as shown in FIG. 6B, the permanent magnet supporter 110 is moved rightly until the connection part 113 is disposed to an end portion of the heat exchange material container 90. Then, in such a state where the pair of the permanent magnets M1 and M2 established at the right and left holding parts are respectively positioned at the left and right portions of the sample S, a uniform magnetic flux density, for instance, about 0.3 T, is applied to the sample S. Preferably, the pair of permanent magnets M1 and M2 are positioned in a state where they face the sample S within 25 mm.

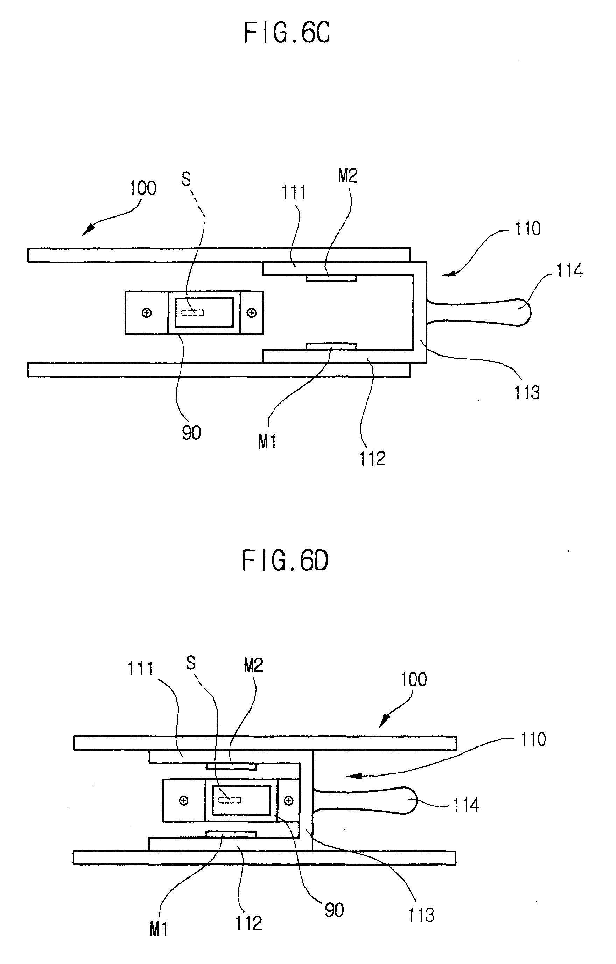

As shown in FIGS. 6C and 6D, if the permanent magnet supporter 110 is moved form the right to the left, so that a change in the polarity of the pair of the permanent magnets M1 and M2 may be caused.

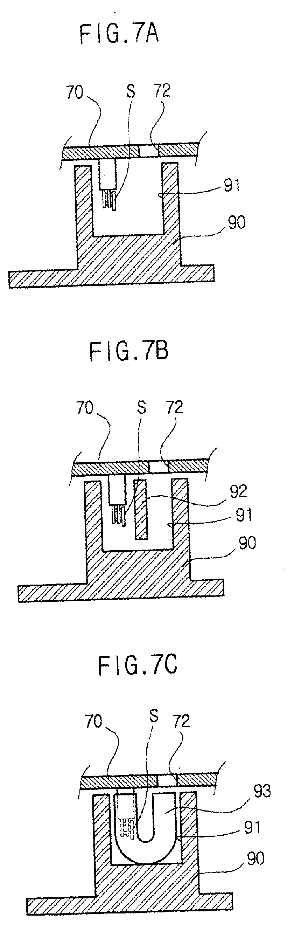

FIGS. 7A to 7C show variously modified examples of the heat exchange material container 90 in accordance with another embodiment of the present invention.

Specifically, FIG. 7A shows a state in which a rectangle-shaped receiving space 91 is formed in the heat exchange material container 90. If the upper cover 70 is opened, the temperature is dropped to an extreme low temperature due to the liquid nitrogen injected through the heat exchange material supplying hole 72.

FIG. 7B shows a modified example of the heat exchange material container 90. Referring to FIG. 7B, a barrier rib 92 is formed in the center of the receiving space 91, and the bottom face of the barrier rib 92 is spaced apart from the bottom face of the receiving space 91 by a predetermined distance. In such a heat exchange material container, the sample S is mounted on one side of the barrier rib 92, and the liquid nitrogen is supplied through the other side thereof. Therefore, the temperature of the sample is not changed immediately to the extreme low temperature, but a level of the liquid nitrogen rises gradually from the bottom face of the receiving space 91. Thus, since the sample S is not directly contacted with the liquid nitrogen, it can be prevented that an abrupt thermal deviation exerts impact on the sample.

FIG. 7C shows a heat exchange material receiving space defined by a U-shaped heat insulating material 93 established within the receiving space 91. In such a structure, as in the modified example shown in FIG. 7B, the sample S is not directly contacted with the liquid nitrogen but it is contacted with the liquid nitrogen after a predetermined time delay. Therefore, error occurrence problems in measured values caused by a thermal impact followed by the heat exchange of the sample S within a short time can be prevented. Also, the emission of the heat to the exterior can be prevented by the heat insulating material 93.

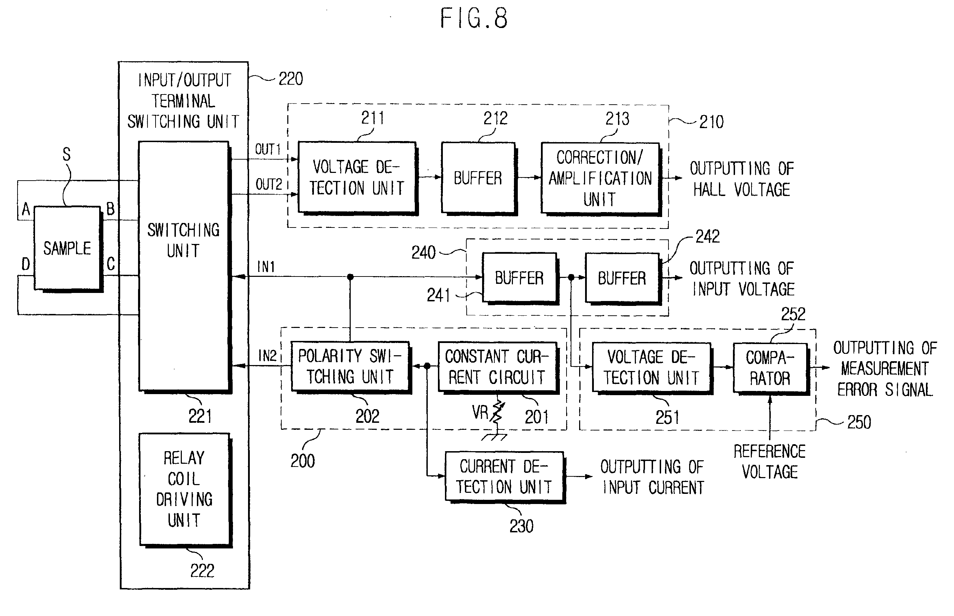

FIG. 8 is a circuit diagram showing an embodiment of a Hall voltage measurement unit applied to the apparatus for measuring the Hall effect in accordance with the present invention.

Referring to FIG. 8, the present invention includes a constant current supplying unit 200, a Hall voltage detection unit 210, an input/output terminal switching unit 220, a current detection unit 230, an input voltage detection unit 240 and a measurement error detection unit 250.

The constant current supplying unit 200 supplies the constant current to selected two terminals among terminals A, B, C and D of the sample S, and it enables to change a level of the constant current. The Hall voltage detection unit 210 detects a Hall voltage outputted from the unselected two terminals and outputs the detected Hall voltage. The input/output terminal switching unit 220 applies the output current of the constant current supplying unit 200 to the selected two terminals depending on the user's manipulation, and performs a switching operation to output the Hall voltages of the unselected two terminals to the Hall voltage detection unit 210. The current detection unit 230 detects the level of the constant current that the constant current supplying unit 200 outputs to the sample. The input voltage detection unit 240 detects the applied voltage of the sample S depending on the constant current that the current supplying unit 200 outputs to the sample S. The measurement error detection unit 250 detects the measurement error of the sample S using the applied voltage of the sample S depending on the constant current that the constant current supplying unit 200 outputs to the sample S.

The constant current supplying unit 200 includes a constant current circuit 201 and a polarity switching unit 202. The constant current circuit 201 outputs the constant current and is capable of changing the level of the constant current. The polarity switching unit 202 switches the polarity of the output current of the constant current circuit 201 to output the polarity-switched output current to the selected two terminals of the sample S via the input/output terminal switching unit 220.

The Hall voltage detection unit 210 includes a voltage detection unit 211, a buffer 212 and a correction/amplification unit 213. The voltage detection unit 211 detects the Hall voltages, which are outputted from the selected two terminals of the sample S, through the input/output terminal switching unit 220. The buffer 212 amplifies the output voltage of the voltage detection unit 211. The correction/amplification unit 213 corrects and amplifies the output voltage of the buffer 212 and outputs the corrected and amplified output voltage.

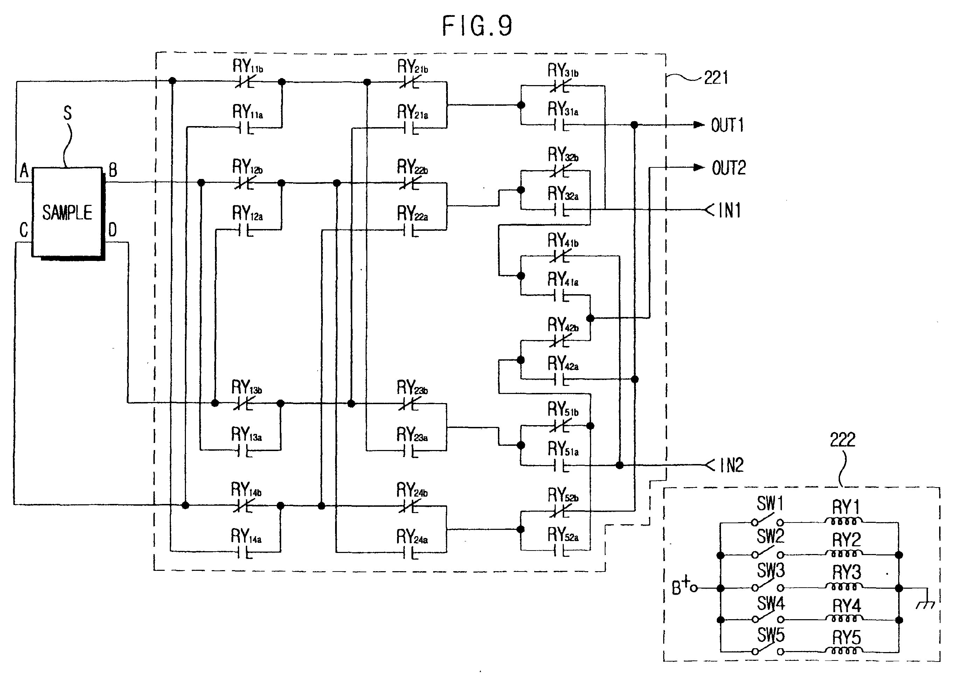

The input;/output terminal switching unit 220 includes a switching unit 221 and a relay coil driving unit 222. As shown in Fig. 9, the relay coil driving unit 222 also includes switches SW1~SW5 connected according as the user manipulates the plurality of the switch controlling knobs 8, and relay coils RY1~RY5 driven depending on a connection of the switches SW1~SW5. The switching unit 221 includes a plurality of contact points (RY11a~RY14a, RY11b~RY14b) (RY21a~RY24a, RY21b~RY24b) (RY31a, RY32a, RY31b, RY32b) (RY41a, RY42b, RY41b, RY42b) (RY51a, RY52a, RY51b, RY52b), which are switched depending on the driving of the relay coils RY1~RY5, and the terminals A, B, C and D of the sample S are selectively connected to the input terminals IN1 and IN2 and the output terminals OUT1 and OUT2.

Among the plurality of contact points (RY11a~RY14a, RY11b~RY14b) (RY21a~RY24a, RY21b~RY24b) (RY31a, RY32a, RY31b, RY32b) (RY41a, RY42b, RY41b, RY42b) (RY51a, RY52a, RY51b, RY52b) of the relay coils RY1~RY5, the contact points 'a' (RY11a~RY14a) (RY21a~RY24a) (RY31a, RY32a) (RY41a, RY42a) (RY51a, RY52a) are connected when the relay coils RY1~RY5 are driven, and the contact points 'b' (RY11b~RY14b) (RY21b~RY24b) (RY31b, RY32b) (RY41b, RY42b) (RY51b, RY52b) are connected when the relay coils RY1~RY5 are not driven.

The input voltage detection unit 240 also includes buffers 241 and 242 for sequentially amplifying and outputting the applied voltage of the sample S depending on the output current of the constant current supplying unit 200.

The measurement error detection unit 250 also includes a voltage detection unit 251 for detecting the level of the output voltage of the buffer 241, and a comparator 252 for determining a measurement error comparing the output voltage of the voltage detection unit 251 with a predetermined reference voltage.

In case where the Hall voltage measurement unit according to the present invention measures the Hall voltage of the sample S under the condition that the power B+ is on, the user varies a variable resistor VR using the current adjustment knob 7 to thereby accurately adjust the constant current outputted from the constant current circuit 201. Then, the polarity switching unit 202 switches the polarity of the constant current outputted from the constant current circuit 201, and the polarity switched constant current is outputted to the input terminals IN1 and IN2.

In such a state, if all of the switches SW1~SW5 are not connected, the relay coils RY1~RY5 are not driven. Therefore, the contact points (RY11a~RY14a) (RY21a~RY24a) (RY31a, RY32a) (RY41a, RY42a) (RY51a, RY52a) are not connected, and the contact points (RY11b~RY14b) (RY21b~RY24b) (RY31b, RY32b) (RY41b, RY42b) (RY51b, RY52b) are connected.

At this time, if it is assumed that a plus (+) constant current is outputted from the polarity switching unit 202 to the input terminal IN1 and a minus (-) constant current is outputted to the input terminal IN2, the plus (+) constant current of the input terminal IN1 is supplied to the terminal A of the sample S sequentially through the contact points (RY31b, RY21b, RY11b), and the minus (-) constant current of the input terminal IN2 is supplied to the terminal B of the sample S sequentially through the contact points (RY41b, RY32b, RY22b, RY12b). That is, the plus (+) and the minus (-) constant currents are applied to the input terminals A and B of the sample S, respectively.

Then, the sample S outputs the Hall voltage, which has a predetermined level depending on the applied constant current, to the terminals C and D.

At this time, the magnetic fields applied to the sample S depending on the movement of the permanent magnet supporter 210 and the Hall voltages of the sample S generated by a temperature change subject to injecting of the liquid nitrogen are different.

The Hall voltage outputted to the terminal C of the sample S is outputted to the output terminal OUT1 sequentially through the contact points (RY14b, RY24b, RY52b), and the Hall voltage outputted to the terminal D of the sample S is outputted to the output terminal OUT2 sequentially through the contact points (RY13b, RY23b, RY51b, RY42b).

The Hall voltages outputted to the output terminals OUT1 and OUT2 are inputted to the Hall voltage detection unit 210, and the Hall voltage detection unit 210 detects the inputted Hall voltages through the voltage detection unit 211. Then, after the detected Hall voltage is amplified through the buffer 212 and is inputted to the correction/amplification unit 213, the correction/amplification unit 213 corrects and amplifies the inputted Hall voltage, and outputs the corrected and amplified Hall voltages.

At this time, the buffer 241 contained in the input voltage detection unit 240 detects the input voltages of the terminals A and B with respect to the constant current that is outputted from the constant current supplying unit 200 and applied to the sample S through the input/output terminal switching unit 220, and then, the detected input voltage is outputted through the buffer 242.

Additionally, in the measurement error detection unit 250, the voltage detection unit 251 detects the level of the input voltage detected by the buffer 241, and the comparator 252 determines the measurement error of the sample S comparing the detected input voltage with the predetermined reference voltage. Also, the light emitting diode 6 receives a measurement error signal to indicate whether there is the measurement error or not.

In case where the sample S is mounted on the IC socket 20, for example, if a level of the contact resistance is high due to a mounting failure, etc, the Hall voltage of the sample S cannot be measured accurately. Therefore, in the present invention, after detecting the input voltage of the sample S, the measurement error is determined when the detected input voltage is higher than the predetermined reference voltage, and an occurrence of the measurement error is indicated by turning on the light emitting diode 6.

If the measurement of the Hall voltage outputted from the terminals C and D of the sample S is completed while applying a predetermined level of the constant current to the terminals A and B, the polarity switching unit 202 changes the polarity of the constant current, and the Hall voltages outputted through the terminals C and D are detected.

Next, the relay coils RY1~RY5 are selectively driven through the switches SW1~SW5, and the terminals (A, C) (A, D) (B, C) (B, D) (C, D) of the sample S are sequentially set up as the input terminal. Also, the terminals (B, D) (B, C) (A, D) (A, C) (A, B) are set up as the output terminals. Then, the Hall voltage is measured using the above-mentioned method.

Table 1 shows the terminals A, B, C and D of the sample S set up as the input terminals and the output terminals depending on the selective driving of the relay coils RY1~RY5.

[TABLE 1]

| RY1 | RY2 | RY3 | RY4 | RY5 | INPUT TERMINAL | OUTPUT TERMINAL |
|---------|---------|---------|---------|---------|----------------|-----------------|
| STOP | STOP | STOP | STOP | STOP | A, B | C, D |
| STOP | STOP | DRIVING | STOP | DRIVING | B, C | A, D |
| STOP | STOP | STOP | DRIVING | DRIVING | A, C | B, D |
| STOP | DRIVING | STOP | STOP | STOP | C, D | A, B |
| STOP | DRIVING | DRIVING | STOP | DRIVING | A, D | B, C |
| DRIVING | DRIVING | STOP | DRIVING | DRIVING | B, D | A, C |

While applying the constant current to the selected two input terminals among the terminals A, B, C and D of the sample S, the Hall voltage outputted from the unselected two terminals is measured, and the constant current supplied to the sample S and the input voltage of the sample S depending on the constant current are measured. Using the measured values, various data, e.g., Hall coefficient and Hall mobility, related to the sample S can be calculated.

In case where the Hall coefficient and the Hall mobility are calculated, for example, under the conditions that no magnetic field is applied and the constant current $I_{AC}$ is supplied to the terminals A and C of the sample S, a ratio of the Hall voltage $V_{BD}$, outputted via the terminals B and D, to the constant current $I_{AC}$ is calculated using a following equation:

$$R_{AC,BD} = \frac{|V_{BD}|}{I_{AC}} \qquad \text{(Eq. 1)}$$

Next, the magnetic field vertical to the sample S is applied and the Hall voltage $Vf_{BD}$ outputted via the terminals B and D of the sample S is measured, to thereby calculate a ratio of the Hall voltage $Vf_{BD}$ to the constant current $I_{AC}$ using a following equation:

$$Rf_{AC,BD} = \frac{|Vf_{BD}|}{I_{AC}} \qquad \text{(Eq. 2)}$$

where, if $\Delta R_{AC,BD} = Rf_{AC,BD} - R_{AC,BD}$, the Hall coefficient is calculated as follows:

$$R_H = \frac{d}{|b|\rho} \Delta R_{AC,BD} \qquad \text{(Eq. 3)}$$

where, $d$ denotes a thickness of a thin film and $\rho$ denotes a resistivity.

The Hall mobility $\mu_H$ is calculated as follows:

$$\mu_H = \frac{R_H}{\rho} = \frac{d}{|B|\rho} \Delta R_{AC,BD} \qquad \text{(Eq. 4)}$$

where, $B$ denotes a magnetic flux density.

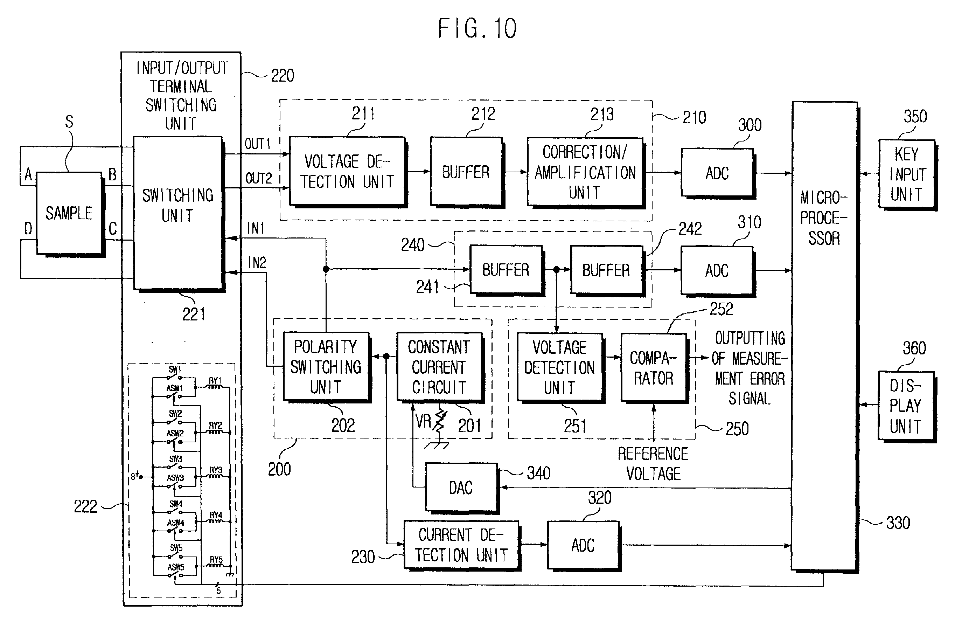

FIG. 10 is a circuit diagram showing another embodiment of the Hall voltage measurement unit for automatically measuring and calculating the Hall coefficient and the Hall mobility in the apparatus for measuring a Hall effect in accordance with the present invention. As shown, another embodiment of the Hall voltage measurement unit includes analog switches ASW1~ASW5, which are connected in parallel with the switches SW1~SW5 and are switched in response to a control signal.

The Hall voltage measurement unit further includes analog-to-digital converters 300, 310 and 320, a microprocessor 330, a digital-to-analog converter 340, a key input unit 350, and a display unit 360.

The analog-to-digital converters 300, 310 and 320 convert output signals of a correction/amplification unit 213, a buffer 242 and a current detection unit 230 into digital signals, respectively. The microprocessor 330 controls an operation of the analog switches ASW1~ASW5, checks the output signals of the analog-to-digital converters 300, 310 and 320, makes the constant current set by a constant current circuit 201 to flow accurately, controls the polarity switching of the polarity switching unit 202, and controls the calculation and the displaying of the Hall coefficient and the Hall mobility using the analog-to-digital converters 300 and 320. The digital-to-analog converter 340 converts the constant current control signal, outputted from the microprocessor, into an analog signal, and applies the analog signal to the constant current circuit 201 contained in the constant current supplying unit 200. The key input unit 350 inputs operation commands into the microprocessor 330 depending on the user's manipulation. The display unit 360 displays the calculated value of the Hall effect depending on the control of the microprocessor 330.

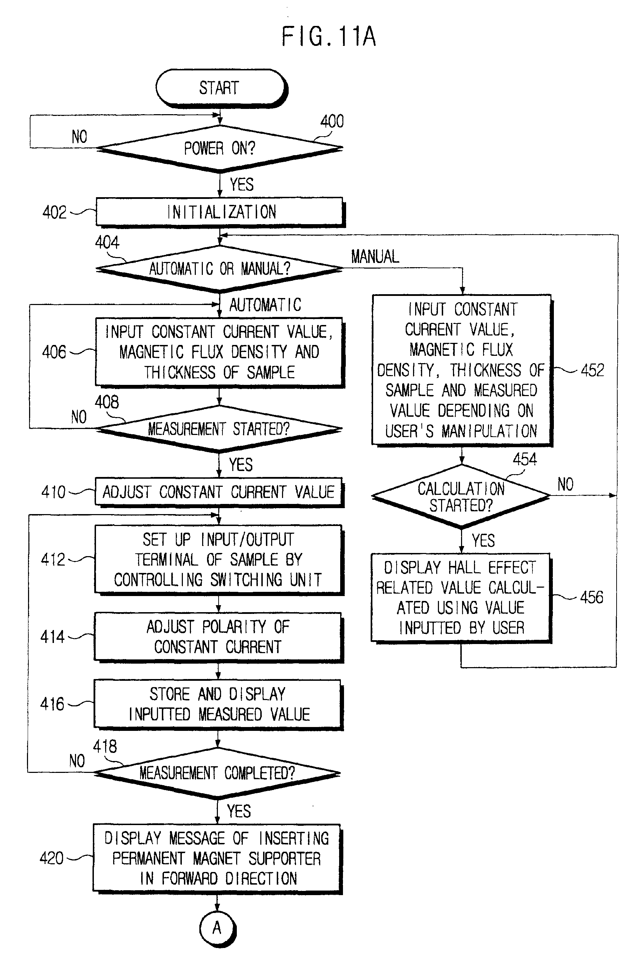

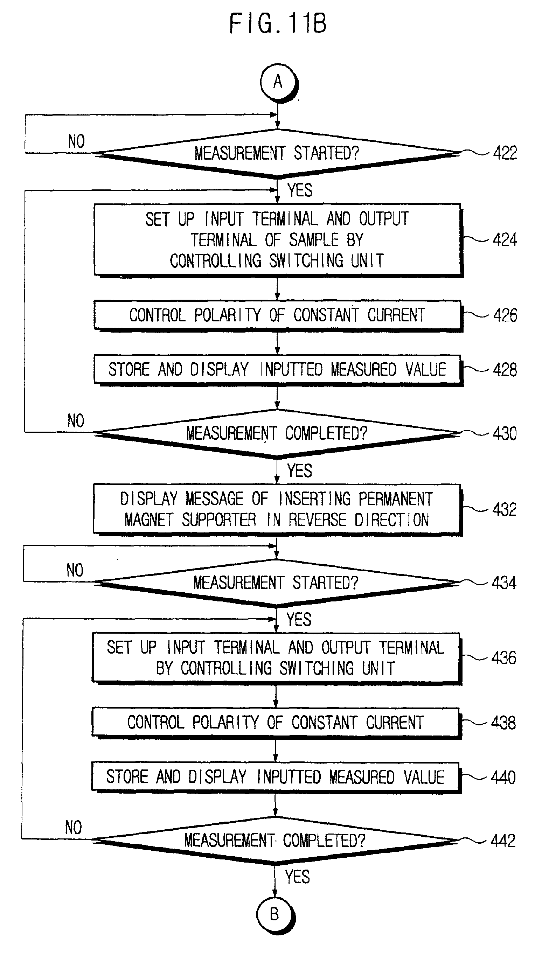

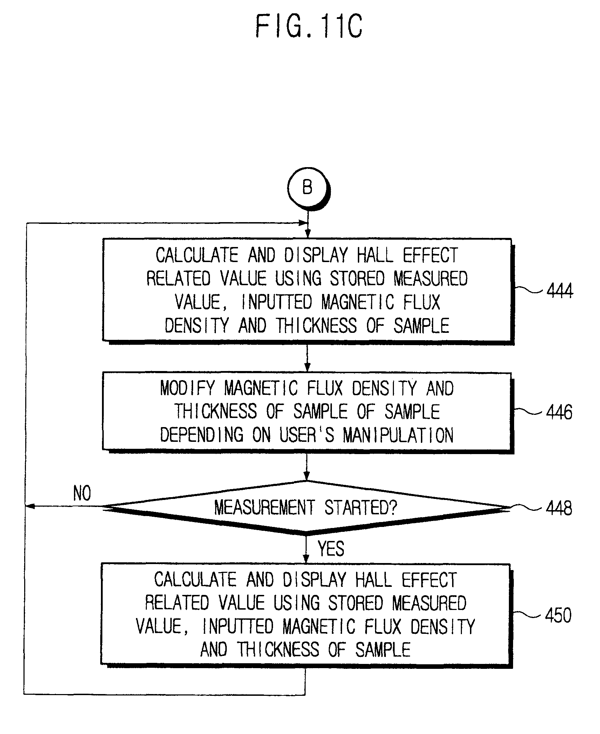

FIGS. 11A to 11C are signal flowcharts showing an operation of the Hall voltage measurement unit illustrated in Fig. 10.

Referring to FIGS. 11A to 11C, at steps 400 and 402, in case where the power is on through the power switch 5, the microprocessor 330 checks the poweron and performs an initial operation.

At step 404, the user manipulates the key input unit 350, and then, it is checked whether the measurement of the Hall effect is set up as an automatic mode or a manual mode. At step 406, if the measurement of the Hall effect is set up as the automatic mode, the value of the constant current to be applied to the sample S, the magnetic flux density induced in the sample S due to the permanent magnets M1 and M2, and the thickness of the sample S are inputted through the key input unit 350.

At steps 408 and 410, if the user commands to start the measurement, the constant current circuit 201 generates the predetermined constant current accurately under the control of the microprocessor 330. That is, the microprocessor 330 outputs a constant current control signal, and the digital-to-analog converter 340 converts the constant current control signal into the analog signal. The analog signal is applied to the constant current circuit 201. Then, the constant current circuit 201 generates the constant current whose level is controlled by the constant current control signal. Also, the constant current outputted from the constant current circuit 201 is inputted to the microprocessor 330 via the current detection unit 230 and the analog-to-digital converter 320. While checking the level of the constant current with signal outputted from analog-to digital converter 320, the microprocessor 330 variably outputs the constant current control signal to the constant current circuit 201 so that the constant current circuit 201 outputs the predetermined constant current accurately.

At step 412, the microprocessor 330 controls the analog switches ASW1~ASW5, contained in the relay coil driving unit 222 of the input/output terminal switching unit 220, to selectively drive the relay coils RY1~RY5. Therefore, the input terminals IN1 and IN2 of the sample S are selectively connected with the output terminals OUT1 and OUT2 thereof. For example, the terminals A and B of the sample S are connected to the input terminals IN1 and IN2, and the terminals C and D are connected to the output terminals OUT1 and OUT2.

At step 414, the polarity of the constant current is adjusted by controlling the polarity switching unit 202.

At step 416, the constant current whose polarity is switched by the polarity switching unit 202 is supplied to the input terminals A and B of the sample S, and the Hall voltage outputted via the terminals C and D depending on the supplied constant current is outputted to the output terminals OUT1 and OUT2. The outputted Hall voltage is inputted to the microprocessor 330 via the Hall voltage detection unit 210 and the analog-to-digital converter 300. Then, the microprocessor 330 measures the Hall voltage.

At step 418, it is checked that whether the measurement of the Hall voltage is completed or not. If the measurement of the Hall voltage is not completed, the step 412 is returned so that the terminals A, B, C and D of the sample S are selectively set up as the input terminals and the output terminals. Then, the measurement of the Hall voltage is repeated while switching the polarity of the constant current.

That is, at the steps 412, 414, 416 and 418, the terminals (A, B) (A, C) (A, D) (B, C) (B, D) (C, D) are set up as the input terminal, and the terminals (C, D) (B, D) (B, C) (A, D) (A, C) (A, B) of the sample S are set up as the output terminal according to the setup of the input terminals. Then, the polarity of the constant current is adjusted by controlling the polarity switching unit 202, and the measurement of twelve Hall voltages outputted from the sample S is performed.

The above measurement is performed under the condition that no magnetic field is formed. At step 420, if it is checked at the step S418 that the measurement of the Hall voltage is completed, the microprocessor 330 controls the display unit 360 to display a message of "insert the permanent magnet supporter 110 into the sample container 40 in a forward direction".

At step 422, after the user inserts the permanent magnet supporter 110 into the sample container 40 in the forward direction, the user commands to start the measurement. At steps 424 to 430, the microprocessor 330 sets up the input terminals and the output terminals of the sample S and measures the Hall voltages while adjusting the polarity of the constant current.

At the steps 424 to 430, the Hall voltages are measured under the condition that the permanent magnet supporter 110 is inserted into the sample container 40 in the forward direction. At step 432, if it is checked at the step 430 that the measurement of the Hall voltages is completed, the display unit 360 displays a message of "insert the permanent magnet supporter 110 into the sample container 40 in a reverse direction".

At step 434, after the user inserts the permanent magnet supporter 110 into the sample container 40 in the reverse direction and commands to start the measurement, the microprocessor 330 again sets up the input terminals and the output terminals of the sample S, and measures the Hall voltages while adjusting the polarity of the constant current.

The measurement operations of the Hall voltage are completed under the conditions that 1) the permanent magnet supporter 110 is not inserted, 2) the permanent magnet supporter 110 is inserted in the forward direction, and 3) the permanent magnet supporter 110 is inserted in the reverse direction. Thereafter, at step 444, the microprocessor 330 calculates the Hall coefficient and the Hall effect related values, e.g., the hole mobility, by substituting a predetermined equation with the saved total measured value, the inputted constant current, the magnetic flux density and the thickness of the sample S, and displays the calculated Hall effect related values.

At step 446, the user modifies the magnetic flux density and the thickness of the sample. Then, at steps 448 and 450, if the user commands to start the measurement, the microprocessor 330 again calculates the Hall effect related values using the modified magnetic flux density and the modified thickness of the samples species S, and displays the calculated Hall coefficient related values.

Meanwhile, at step 452, if the measurement of the Hall effect is set up as the manual mode at the step 404, the measured constant current value, the magnetic flux density and the thickness of the sample and the measured Hall voltage are inputted. At steps 454 and 456, if the user commands to start the measurement, the Hall effect related values are calculated using the inputted values, and the calculated Hall effect related values are displayed.

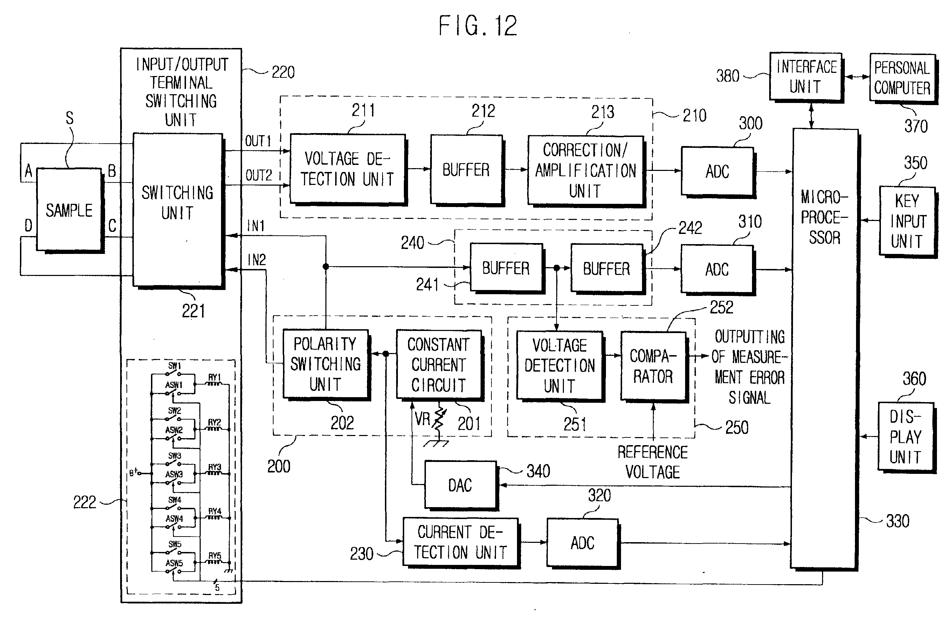

FIG. 12 is a circuit diagram showing a further another embodiment of the Hall voltage measurement unit in accordance with the present invention.

Referring to FIG. 12, the Hall voltage measurement unit in accordance with further another embodiment of the present invention includes a personal computer 370 and an interface unit 380. The personal computer 370 controls the microprocessor 330 to set up the constant current, measures the Hall voltage and the input voltage, and calculates the Hall effect related values by inputting the measured Hall voltage and input voltage. The interface unit 380 is disposed between the microprocessor 330 and the personal computer 370 and interfaces data therebetween.

In the further another embodiment having such a structure, by manipulating the personal computer 370, the user commands to the microprocessor 330 to measure the Hall voltage and the input voltage. Then, the personal computer 370 receives the measured values via the interface unit 380 and calculates the Hall effect related values.

As mentioned above, in the apparatus for measuring the Hall effect according to the present invention, the liquid nitrogen used as the heat exchange material is injected into a small-sized heat shield container and the small-sized permanent magnets are used as a magnetic body for forming the magnetic field to the sample. Therefore, it is possible to measure the Hall voltage using a simple structure and the investment cost can be remarkably reduced.

Additionally, the process of injecting the liquid nitrogen is simple, and it is easy to move the permanent magnets to the heat shield container on which the sample is mounted, thereby simplifying the total measuring operations.

Furthermore, since the sample and the Hall voltage measurement unit are electrically connected using the IC sockets capable of setting at least one sample, it is possible to measure a plurality of samples continuously. The sample holder for setting the sample is not limited in the IC socket, but various kinds of targets are applicable thereto.

Meanwhile, since the Hall voltage measurement unit of the present invention includes the measurement error detection unit for detecting the measurement error using the level of the input voltage depending on the constant current that is outputted from the constant current supplying unit to the sample, the measurement error is detected before measuring the Hall voltage, thereby excluding the measurement error.

The user can measures the Hall effect in the automatic mode or the manual mode according to his/her convenience.

While the present invention has been described in detail, it should be understood that various changes, substitutions and alterations could be made hereto without departing from the spirit and scope of the invention as defined by the appended claims.

**Claims**

**1.** An apparatus for measuring a Hall effect, comprising:

a sample holder on which a sample is set;
a sample container which is provided with the sample holder;
a permanent magnet supporter in which a pair of permanent magnets are established facing with each other, the permanent magnet supporter being attachably and detachably coupled with the sample container such that the sample is positioned between the pair of permanent magnets; and
a Hall voltage measurement means for applying a current to the sample and measuring a Hall voltage outputted from the sample.

**2.** The apparatus of claim 1, wherein the sample container has a heat exchange material supplying hole for supplying a heat exchange material.

**3.** The apparatus of claim 1 or 2, wherein the sample holder comprises an IC socket in which a plurality of samples can be mounted.

**4.** The apparatus of claim 1, 2 or 3 wherein the sample container comprises:

a top case on which a sample holder is installed; and
a bottom case coupled with the top case,

wherein a part of a lower face of the bottom case is supported by a pedestal, the pedestal having a pair of guide rails extending therefrom and placed below a remaining portion of the lower face of the bottom case, for guiding a movement of the permanent magnet supporter.

5.   The apparatus of claim 4, wherein the permanent magnet supporter comprises:

a pair of fixing parts to which the pair of permanent magnets are fixed; and
a connection part connected to the fixing parts thereby to maintain a constant

interval between the fixing parts.

6.   The apparatus of claim 4 or 5, wherein the bottom case comprises a heat insulating material formed at an inner surface thereof.

7.   The apparatus of claim 1, 2 or 3 wherein the sample container comprises:

a top cover on which a sample holder is mounted and in which a heat exchange material supplying hole is formed;
a heat exchange material container having a receiving space for containing the heat exchange material;
a pair of guide plates established at respective sides of the heat exchange material container; and
a pedestal for supporting the heat exchange material container and the pair of guide plates.

8.   The apparatus of claim 7, wherein the permanent magnet supporter is moved on the pedestal while enclosing the heat exchange material container within the pair of guide plates.

9.   The apparatus of claim 7 or 8, wherein the heat exchange material container comprises a heat insulating material.

10.  The apparatus of claim 7, 8 or 9 wherein the sample container includes a barrier rib formed crossing the receiving space thereof and spaced apart from a bottom face of the receiving space by a predetermined distance.

11.  The apparatus of claim 7, 8 or 9 wherein the sample container comprises a the exchange material receiving space defined by a U-shaped heat insulating material inserted into an inside of the receiving space, the U-shaped heat insulating material having one end communicating with the heat exchange material supplying hole and the other end in which the sample is placed.

12.  The apparatus of any preceding claim, wherein the Hall voltage measurement means comprises:

a constant current supplying unit for supplying a constant current to two terminals selected among plurality of terminals of the sample and for varying a level of the constant current;
a Hall voltage detection unit for detecting a Hall voltage outputted from the unselected two terminals of the sample and outputting the detected Hall voltage;
a switching unit for applying an output current of the constant current supplying unit to the selected two terminals depending on a user's manipulation, and for outputting the Hall voltage of the unselected two terminals to the Hall voltage detection unit;
a current detection unit for detecting a level of the constant current which the constant current supplying unit outputs to the sample and
an input voltage detection unit for detecting an input voltage of the sample depending on the constant current which the constant current supplying unit outputs to the sample.

13.  The apparatus of claim 12, further comprising a measurement error detection unit for detecting a measurement error of the sample using the level of the input voltage of the sample depending on the current constant which the constant current supplying unit outputs to the sample.

14.  The apparatus of claim 13, wherein the measurement error detection unit comprises:

a voltage detection unit for detecting the level of an input voltage of the sample depending on the constant current which the constant current supplying unit outputs to the sample; and
a comparator for comparing the output voltage of the voltage detection unit with a predetermined reference voltage and determining whether there is a measurement error or not.

15.  The apparatus of claim 12, 13 or 14 wherein the Hall voltage measurement means comprises:

a plurality of analogue-to-digital converters for converting the output signals of the Hall voltage detection unit, the input voltage detection unit and the current detection unit into digital signals;

a microprocessor for controlling a switching operation of the switching unit, determining the output current of the constant current supplying unit using a digital signal which is outputted from the current detection unit and converted by the analog-to-digital converter, adjusting the set constant current to output, controlling a polarity of the constant current, and calculating a Hall coefficient-related value using a digital signal which is outputted from the Hall voltage detection unit and the input voltage detection unit and converted by the analog-to-digital conversion unit, and displaying the calculated the Hall coefficient related value;

a key input unit for inputting operation commands to the microprocessor depending on the user's manipulation; and

a display unit for displaying a calculated value of the Hall effect depending on the control of the microprocessor.

16. The apparatus of claim 15, wherein the Hall voltage measurement means comprises:

a personal computer for setting the constant current by controlling the microprocessor, measuring the Hall voltage and the input voltage, and calculating the Hall co-efficient-related value by inputting the measured Hall voltage and input voltage; and

an interface unit disposed between the microprocessor and the personal computer, for interfacing data therebetween.

17. A method for measuring a Hall coefficient, comprising the steps of:

a) inputting a constant current to be applied to a sample, a magnetic flux density and a thickness of the sample;

b) adjusting a level of the constant current such that the inputted current is supplied to the sample;

c) sequentially setting four terminals of the sample as two input terminals and two output terminals, and measuring a Hall voltage outputted from the sample and an input voltage of the sample while adjusting polarities of the constant current;

d) inserting a permanent magnet supporter in a forward direction, sequentially setting as the input terminal and the output terminal of the sample and measuring the Hall voltage outputted from the sample and the input voltage of the sample while adjusting polarities of the constant current;

e) inserting the permanent magnet supporter in a reverse direction, sequentially setting as the input terminal and the output terminal of the sample, and measuring the Hall voltage outputted from the sample and the input voltage of the sample while adjusting polarities of the constant current; and

f) substituting a predetermined equation with the values measured in the steps c) to e), and calculating and displaying a Hall coefficient related value

18. The method of claim 17, wherein the step f) comprises a step of modifying the magnetic flux density and the thickness of the sample depending on the user's manipulation, and, if a calculation start command is inputted, calculating again the Hall coefficient-related value using the modified magnetic flux density and the modified thickness of the sample and the measured value, and displaying the calculated Hall coefficient related value.

19. The method of claim 17, wherein, if the user sets up a manual mode, the constant current applied to the sample, the magnetic flux density and the thickness of the sample, the Hall voltage and the input voltage of the sample are inputted and the Hall coefficient related value is calculated and the calculated Hall coefficient related value is displayed.

FIG.1

EP 1 211 517 A2

# FIG.2

EP 1 211 517 A2

# FIG.3A

# FIG.3B

FIG.4

EP 1 211 517 A2

EP 1 211 517 A2

FIG.5

# FIG.6A

# FIG.6B

# FIG.6C

# FIG.6D

## FIG.7A

## FIG.7B

## FIG.7C

FIG.8

EP 1 211 517 A2

# FIG.9

EP 1 211 517 A2

## FIG.10

EP 1 211 517 A2

# FIG. 11A

START

400

NO ← POWER ON?

YES

402 — INITIALIZATION

404 — AUTOMATIC OR MANUAL? —— MANUAL

AUTOMATIC

406 — INPUT CONSTANT CURRENT VALUE, MAGNETIC FLUX DENSITY AND THICKNESS OF SAMPLE

452 — INPUT CONSTANT CURRENT VALUE, MAGNETIC FLUX DENSITY, THICKNESS OF SAMPLE AND MEASURED VALUE DEPENDING ON USER'S MANIPULATION

408

NO ← MEASUREMENT STARTED?

YES

410 — ADJUST CONSTANT CURRENT VALUE

454 — CALCULATION STARTED? —— NO

YES

412 — SET UP INPUT/OUTPUT TERMINAL OF SAMPLE BY CONTROLLING SWITCHING UNIT

456 — DISPLAY HALL EFFECT RELATED VALUE CALCULATED USING VALUE INPUTTED BY USER

414 — ADJUST POLARITY OF CONSTANT CURRENT

416 — STORE AND DISPLAY INPUTTED MEASURED VALUE

418

NO ← MEASUREMENT COMPLETED?

YES

420 — DISPLAY MESSAGE OF INSERTING PERMANENT MAGNET SUPPORTER IN FORWARD DIRECTION

A

# FIG.11B

(A)

MEASUREMENT STARTED? ~ 422

NO

YES

SET UP INPUT TERMINAL AND OUTPUT TERMINAL OF SAMPLE BY CONTROLLING SWITCHING UNIT ~ 424

CONTROL POLARITY OF CONSTANT CURRENT ~ 426

STORE AND DISPLAY INPUTTED MEASURED VALUE ~ 428

MEASUREMENT COMPLETED? ~ 430

NO

YES

DISPLAY MESSAGE OF INSERTING PERMANENT MAGNET SUPPORTER IN REVERSE DIRECTION ~ 432

MEASUREMENT STARTED? ~ 434

NO

YES

SET UP INPUT TERMINAL AND OUTPUT TERMINAL BY CONTROLLING SWITCHING UNIT ~ 436

CONTROL POLARITY OF CONSTANT CURRENT ~ 438

STORE AND DISPLAY INPUTTED MEASURED VALUE ~ 440

MEASUREMENT COMPLETED? ~ 442

NO

YES

(B)

# FIG.11C

B

CALCULATE AND DISPLAY HALL EFFECT
RELATED VALUE USING STORED MEASURED
VALUE, INPUTTED MAGNETIC FLUX
DENSITY AND THICKNESS OF SAMPLE — 444

MODIFY MAGNETIC FLUX DENSITY AND
THICKNESS OF SAMPLE OF SAMPLE
DEPENDING ON USER'S MANIPULATION — 446

NO ◁ MEASUREMENT STARTED? ▷ — 448

YES

CALCULATE AND DISPLAY HALL EFFECT
RELATED VALUE USING STORED MEASURED
VALUE, INPUTTED MAGNETIC FLUX DENSITY
AND THICKNESS OF SAMPLE — 450

# FIG.12

EP 1 211 517 A2